# EUROPEAN PATENT SPECIFICATION

(11) **EP 3 250 015 B1**
(45) Date of publication and mention of the grant of the patent: **04.03.2020**
(21) Application number: 16740465.6
(22) Date of filing: 18.01.2016
(51) Int. Cl.: H05K 7/00, H04Q 1/06

(54) **DEVICE FOR INSTALLING PATCH CORDS IN A TELECOMMUNICATIONS RACK (CABINET)**
VORRICHTUNG ZUR INSTALLATION VON STECKSCHNÜREN IN EINEM TELEKOMMUNIKATIONSRACK (-SCHRANK)
DISPOSITIF POUR RANGER LES CORDONS DE COMMUTATION DANS UNE COLONNE (UNE ARMOIRE) DE TÉLÉCOMMUNICATION

(30) Priority: 20.01.2015 RU 2015101356
(43) Date of publication of application: 29.11.2017
(73) Proprietor: OBSCHESTVO S OGRANICHENNOY OTVETSTVENNOSTYU "UCABLE", Moscow, 143026 (RU)
(72) Inventor: Khozyainov, Boris Alekseevich, Moskovskaya obl., 141077 (RU)
(74) Representative: Chimini, Francesco
(86) International application number: PCT/RU2016/000010
(87) International publication number: WO 2016/118049

(56) References cited:
- RU-C1- 2 372 699
- RU-C1- 2 421 859
- RU-U1- 126 551
- US-A- 4 770 357
- US-A- 4 770 357
- US-A1- 2012 195 019
- US-B1- 6 741 784
- US-B2- 8 655 137

## Description

### Field of the Invention

The present invention relates to communication technology and may be used for laying patch cords in a telecommunication rack (cabinet).

### Background of the Invention

Currently, in server rooms and data centers are commonly used apparatuses for laying patch cords in a telecommunication rack (cabinet), or cable organizers (managers). Patch cords have a fixed length, and the nomenclature of the patch cord lengths is limited. A distance between network ports in a rack does not usually coincide with a patch cord length, therefore, when connecting server ports in a rack by a patch cord, an excess of the patch cord emerges, and that excess is laid in loops into apparatuses for laying patch cords.

A disadvantage of such apparatuses consists in that the patch cord loops are in contact, and the patch cords are jumbled.

US 2012/195019 A1 discloses an example of a cord management assembly for data communication patching systems.

### Summary of the Invention

Thus, the object of the present invention consists in developing such an apparatus for laying patch cords that prevents the jumbling of patch cord cable loops.

In order to achieve said technical result, the present invention provides an apparatus for laying patch cords in a telecommunication rack (cabinet), wherein said apparatus: having at least one cavity (hollow interspace) for laying a patch cord cable, at least 80 % of volume of the cavity are disposed behind the front panel of the apparatus in the depth of the rack (cabinet) after placing the apparatus into the rack (cabinet); having an aperture at the front panel, which aperture permitting to lay the patch cord cable in the cavity in such a manner that the patch cord cable folded with a bend and passing through the aperture even number of times crosses at least one imaginary geometric plane passing through three points disposed at the front panel.

The cavity of the apparatus for laying patch cords may have stops preventing the movement of the patch cord cable laid in the cavity into another cavity of the apparatus for laying patch cords. Moreover, the cavity may also have stops preventing the movement of the patch cord cable laid in the cavity into the depth of the rack (cabinet). The stops may be made in the form of walls or stems.

The cavity in the apparatus for laying patch cords may have a composite structure, wherein the depth of the cavity varies by selecting the number of joined structural members.

The cavity may be made of plastic or metal.

The apparatus for laying patch cords may additionally comprise a device for laying a cable in the cavity, which device consisting of a stem and a means ensuring the minimal cable bend radius, which stem and means may be fasten using constant magnets.

The apparatus for laying patch cords may be used for optical or twisted pair cables.

In some instances, the apparatus for laying patch cords may have common body with a cord panel. In this case, the panel may be an optical one provided with LC connectors.

The apparatus for laying patch cords may comprise a device for carrying a patch cord cable horizontally, and have a height of one or two units (U).

The apparatus for laying patch cords may have 24 or more cavities.

A cable having the outer diameter of not more than 4 mm may be placed in the cavity of the apparatus for laying patch cords. Herewith, such cable may occupy more than one cavity in that apparatus.

And finally, the cavity of that apparatus may have dimensions enabling to place the patch cord cable by bending the cable with a radius not more than the minimal bend radius thereof.

### Brief Description of Drawings

In all figures, the same reference numbers mark the same or similar elements.
Fig. 1 shows the front view of the apparatus for laying patch cords in a telecommunication rack (cabinet).
Fig. 2 shows the plan view of the apparatus for laying patch cords in a telecommunication rack (cabinet).
Fig. 3 shows the side elevation view of the cavity stops made in the form of cylinders.
Fig. 4 shows the plan view of device for laying a cable in the cavity.
Fig. 5 shows the side elevation view of device for carrying a patch cord cable horizontally.
Fig. 6 shows the front view of the apparatus for laying patch cords in a telecommunication rack (cabinet) being in coincidence with the cord panel.

### Detailed Description of the Invention

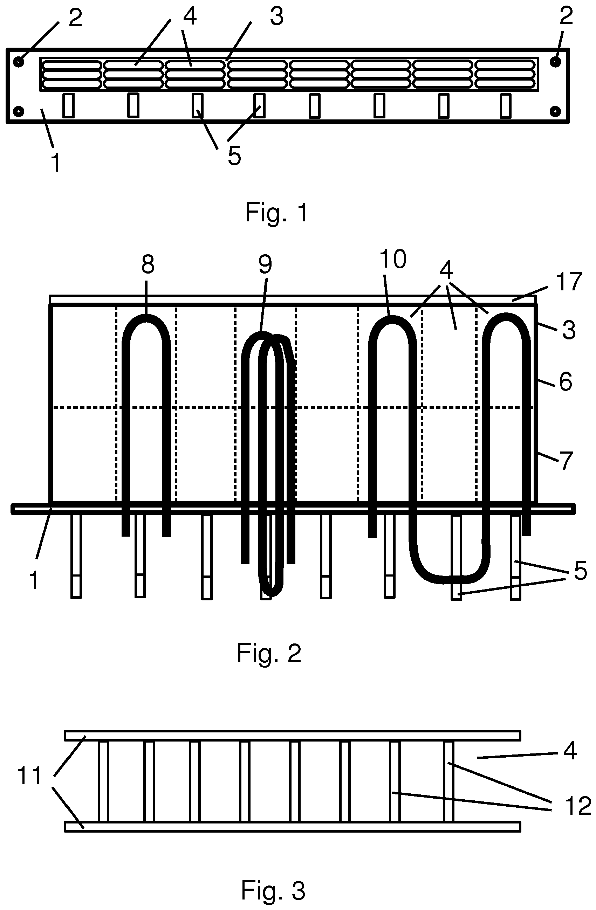

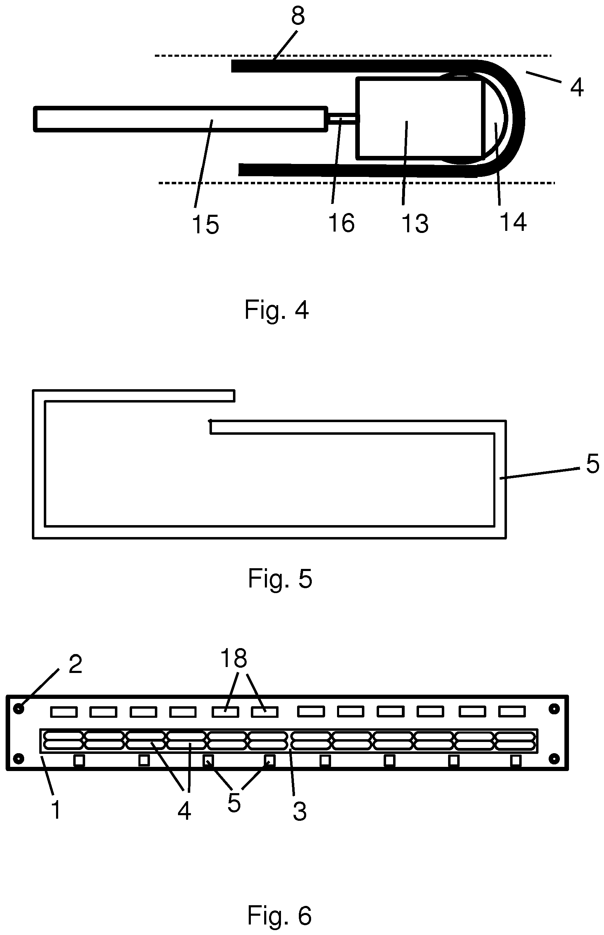

Fig. 1 shows the front view of the apparatus for laying patch cords in a telecommunication rack (cabinet). A front plate 1 made from a sheet of plastic or metal has holes 2 for fastening to the rails of the telecommunication rack. Usually, the apparatus for laying patch cords may have a device for carrying a patch cord cable horizontally, which device may be made, for example, from a metal strip bent as shown in Fig. 5. A distinctive feature of the apparatus for laying patch cords in accordance with the present invention consists in existence of cavities (hollow interspace) 4, three rows with eight cavities in each row, organized in an assembly 3. The assembly 3 with the cavities 4 may be made by molding or cutting. As shown in Fig. 2, the assembly 3 may consist of several parts (reference numbers 6 and 7 divided in Fig. 2 by a horizontal dashed line). The members 6 and 7 may be joined together end-to-end using pins. By varying the number of the members similar to 6 and 7, the cavities of different depth may be made. Fig. 2 shows the sectional plan view of one of said rows of cavities 4 divided by vertical dashed lines. Here are also shown variants of laying a patch cord cable in the cavity 4 (cable connectors are not shown). The most typical is the variant, when a fragment of the cable 8 is folded and pushed with its bend into one of the cavities 4. Thus, having a depth of the cavity 4 equal to 450 mm, an excess of the patch cord cable up to 900 mm may be inserted into the cavity. In this case, a width of the cavity must be such for ensuring the minimum permissible bent radius of the cable; for the UTP wires having the outer diameter of about 6 mm, such radius is equal to 25 mm. If the dimensions of the cavity 4 permit that, then the excess of the patch cord cable may be laid as shown in position 9. When using the patch cords of a small diameter (for example, the Pandiut SD series having the diameter of 3.8 mm), then the permissible bent radius decreases to 15 mm, and the height of the cavity decreases also. Thus, the apparatus for laying patch cords may have twice as many cavities 4, for example, 48. If using a typical cord panel for 24 ports, some patch cords having a small diameter (or usual diameter, but in small quantity) may occupy more than one cavity 4, as shown in position 10 in Fig. 2, and twice as much cable excesses may be laid in the cavity. It is clear from Fig. 2 that each of cables crosses even number of times at least one imaginary geometric plane passing through three points disposed at the front panel 1: the cable 8 crosses it 2 times, and the cables 9 and 10 - 4 times.

In order for preventing the jumbling of patch cord cables, the cavity interspaces are separated from one another by stops preventing the movement of the patch cord cable laid in the cavity into another cavity. The stops may be made in the process of molding in the form of walls (in this case, the walls may project forward from the front panel for imparting stiffness). In order for the bent portion of the patch cord cable not step out of the cavity in the cabinet recess and not jumble with another cable, one more stop may be used. It is represented by the reference number 17 in Fig. 2, made in the form of wall, i.e. plate fixed at the member 6, for example, by pins or glue.

The stops of the cavity 4 may be made in another way (Fig. 3). If two parallel plates 11 are joined together by cylindrical stems 12 mounted so frequently that the folded cable does not pass between them, then a fully functional cavity results.

For convenience, the apparatus for laying patch cords in a telecommunication rack (cabinet) may be equipped with a device for laying a cable in the cavity 4 shown in Fig. 4. The device for laying a cable in the cavity comprises a means 13 ensuring the minimal cable bend radius and having a roller 14, and a push bar 15. The push bar 15 may be connected with the means 13 ensuring the minimal cable bend radius using a finger 16 that may be separable or glued to the means 13. If the finger 16 is glued, then the device for laying a cable in the cavity is fully extracted from the cavity. If the connection between the push bar 15 and the means 13 ensuring the minimal cable bend radius is detachable, then, after the push bar 15 being extracted from the cavity 4, the means 13 ensuring the minimal cable bend radius is remained in the cavity and ensures the maintenance of the minimal cable bend radius, which is particularly topical for optical patch cords. The means 13 may be equipped with a constant magnet for the convenient extraction. If one end of the push bar 15 has also the constant magnet, then the end without the magnet may put the means 13 leaving it in the cavity 4, and the end with the magnet may extract the means 13.

It is evident, that the structure of the apparatus for laying patch cords in a telecommunications rack in accordance with the present invention may have different height, for example, of 1 or 2 units (1 unit = 44.45 mm).

Sometimes, it is expedient to combine the apparatus for laying patch cords in a telecommunications rack in one body with a patch panel (Fig. 6). For example, an optical patch panel provided with LC connectors for 12 ports (reference number 18 in Fig. 6) requires a low height. The LC cord cable may have a diameter of 2 mm and a bend radius of 15 mm (ITU G.657). Thus, up to 24 cavities 4 may be placed at the space of the front panel 1 having a height of 5 mm. The rest place remaining from the height of 1 unit is more than enough for placing optical ports 18 of the cord panel and devices 5 for carrying a patch cord cable horizontally.

Although the present invention has been described by references to specific embodiments, it is clear for specialists that these illustrative examples, in which various modifications may be made, do not limited the scope of the invention that is determined only by the enclosed claims.

## Claims

1. An apparatus for laying patch cords in a telecommunication rack, the apparatus **characterized in**:
- having at least one cavity (4) for laying a patch cord cable, at least 80 % of volume of said cavity being disposed behind a front panel (1) of said apparatus in the depth of said rack, after placing said apparatus into the rack;
- having an aperture at said front panel, which aperture permitting to lay the patch cord cable in said cavity, a width of the cavity being such for ensuring the minimum permissible bent radius of the cable in such a manner that the patch cord cable folded with a bend and passing through said aperture even number of times crosses at least one imaginary geometric plane passing through three points disposed at said front panel.

2. The apparatus for laying patch cords in accordance with Claim 1, wherein said cavity (4) having stops preventing the movement of the patch cord cable laid in said cavity into another cavity of said apparatus.

3. The apparatus for laying patch cords in accordance with Claim 1, wherein said cavity having stop(-s) preventing the movement of the patch cord cable laid in said cavity into the depth of the rack.

4. The apparatus for laying patch cords in accordance with Claim 2 or 3, wherein said stops being walls (17) or stems (12).

5. The apparatus for laying patch cords in accordance with Claim 1, wherein the depth of said cavity varying by selecting the number of joined members (6, 7) of the structure of said cavity.

6. The apparatus for laying patch cords in accordance with Claim 1, wherein said cavity being plastic or metal.

7. The apparatus for laying patch cords in accordance with Claim 1, wherein said cable being optical or comprising a twisted pair.

8. The apparatus for laying patch cords in accordance with Claim 1, wherein said apparatus having a common body with a patch panel.

9. The apparatus for laying patch cords in accordance with Claim 8, wherein said cord panel being optical.

10. The apparatus for laying patch cords in accordance with Claim 9, wherein said cord panel comprising LC couplers.

11. The apparatus for laying patch cords in accordance with Claim 8, wherein said apparatus comprising a device for carrying a patch cord cable horizontally.

12. The apparatus for laying patch cords in accordance with Claim 1, wherein said apparatus having a height of one or two units, where 1 unit = 44.45 mm.

13. The apparatus for laying patch cords in accordance with Claim 1, wherein said apparatus having 24 or more cavities.

14. The apparatus for laying patch cords in accordance with Claim 1, wherein said cable occupying more than one said cavity.

15. The apparatus for laying patch cords in accordance with Claim 1, wherein said cavity having dimensions enabling to place said patch cord cable by bending said cable with a radius not more than the minimal bend radius thereof.

## Patentansprüche

1. Apparat zum Verlegen von Patchleitungen in einem Telekommunikationsrack, wobei der Apparat **dadurch gekennzeichnet ist, dass** er:
- mindestens einen Hohlraum (4) zum Verlegen eines Patchleitungskabels aufweist, wobei mindestens 80 % des Hohlraumvolumens hinter einer Frontplatte (1) des Apparats in der Tiefe des Racks angeordnet ist, nachdem der Apparat in das Rack platziert wurde;
- einen Durchlass bzw. eine Öffnung in der Frontplatte aufweist, der das Verlegen des Patchleitungskabels in den Hohlraum erlaubt, wobei eine Breite des Hohlraums so ausgelegt ist, um den minimal zulässigen Biegeradius des Kabels so zu gewährleisten, dass das mit einer Biegung gefaltete bzw. geknickte und den Durchlass bzw. die Öffnung eine gerade Anzahl an Malen durchlaufende Patchleitungskabel mindestens eine gedachte geometrische Ebene durchquert, die drei an der Frontplatte angeordnete Punkte durchläuft.

2. Apparat zum Verlegen von Patchleitungen nach Anspruch 1, wobei der Hohlraum (4) Anschläge aufweist, die das Bewegen bzw. Verschieben des in dem Hohlraum verlegten Patchleitungskabels in einen anderen Hohlraum des Apparats hinein verhindert.

3. Apparat zum Verlegen von Patchleitungen nach Anspruch 1, wobei der Hohlraum einen oder mehrere Anschläge zum Verhindern des Bewegens bzw. Verschieben des in dem Hohlraum verlegten Patchleitungskabels in die Tiefe des Racks hinein aufweist.

4. Apparat zum Verlegen von Patchleitungen nach Anspruch 2 oder 3, wobei die Stopps Wände (17) oder Stiele (12) sind.

5. Apparat zum Verlegen von Patchleitungen nach Anspruch 1, wobei die Tiefe des Hohlraums durch Auswählen der Anzahl verbundener Elemente (6, 7) der Hohlraumstruktur variiert.

6. Apparat zum Verlegen von Patchleitungen nach Anspruch 1, wobei der Hohlraum aus Kunststoff oder Metall besteht.

7. Apparat zum Verlegen von Patchleitungen nach Anspruch 1, wobei das Kabel ein optisches ist oder ein verdrilltes Doppelkabel umfasst.

8. Apparat zum Verlegen von Patchleitungen nach Anspruch 1, wobei der Apparat ein gewöhnliches Gehäuse mit einer Patchtafel aufweist.

9. Apparat zum Verlegen von Patchleitungen nach Anspruch 8, wobei die Schaltplatte eine optische ist.

10. Apparat zum Verlegen von Patchleitungen nach Anspruch 9, wobei die Kabelplatte LC-Koppler umfasst.

11. Apparat zum Verlegen von Patchleitungen nach Anspruch 8, wobei der Apparat ein Gerät zum horizontalen Tragen bzw. Führen eines Patchleitungskabels umfasst.

12. Apparat zum Verlegen von Patchleitungen nach Anspruch 1, wobei der Apparat eine Höhe von ein oder zwei Einheiten aufweist, wobei 1 Einheit = 44,45 mm.

13. Apparat zum Verlegen von Patchleitungen nach Anspruch 1, wobei der Apparat 24 oder mehr Hohlräume aufweist.

14. Apparat zum Verlegen von Patchleitungen nach Anspruch 1, wobei das Kabel mehr als einen der Hohlräume belegt.

15. Apparat zum Verlegen von Patchleitungen nach Anspruch 1, wobei der Hohlraum Dimensionen aufweist, die das Platzieren des Patchleitungskabels durch Biegen des Kabels mit einem Radius ermöglicht, der den minimalen Biegeradius dessen nicht überschreitet.

## Revendications

1. Dispositif pour ranger des cordons de brassage dans une armoire de télécommunication, le dispositif étant **caractérisé en ce qu'**il comprend :
- au moins une cavité (4) pour ranger un câble de cordon de brassage, au moins 80% de volume de ladite cavité étant disposé derrière un panneau avant (1) dudit dispositif dans la profondeur de ladite armoire, après la mise en place dudit dispositif dans l'armoire ;
- une ouverture au niveau dudit panneau avant, laquelle ouverture permettant de ranger le câble de cordon de brassage dans ladite cavité, une largeur de la cavité étant telle qu'elle garantisse le rayon de courbure minimal admissible du câble de manière que le câble de cordon de brassage plié avec un coude et traversant ladite ouverture un nombre pair de fois coupe au moins un plan géométrique imaginaire passant par trois points disposés au niveau dudit panneau avant.

2. Dispositif pour ranger des cordons de brassage selon la revendication 1, dans lequel ladite cavité (4) comporte des butées empêchant le mouvement du câble de cordon de brassage rangé dans ladite cavité dans une autre cavité dudit dispositif.

3. Dispositif pour ranger des cordons de brassage selon la revendication 1, dans lequel ladite cavité comporte un ou des butées empêchant le mouvement du câble de cordon de brassage rangé dans ladite cavité dans la profondeur de l'armoire.

4. Dispositif pour ranger des cordons de brassage selon la revendication 2 ou 3, dans lequel lesdites butées sont des parois (17) ou des tiges (12).

5. Dispositif pour ranger des cordons de brassage selon la revendication 1, dans lequel la profondeur de ladite cavité varie en sélectionnant le nombre d'éléments assemblés (6, 7) de la structure de ladite cavité.

6. Dispositif pour ranger des cordons de brassage selon la revendication 1, dans lequel ladite cavité est en plastique ou en métal.

7. Dispositif pour ranger des cordons de brassage selon la revendication 1, dans lequel ledit câble est optique ou comprend une paire torsadée.

8. Dispositif pour ranger des cordons de brassage selon la revendication 1, dans lequel ledit dispositif a un corps commun avec un panneau de brassage.

9. Dispositif pour ranger des cordons de brassage selon la revendication 8, dans lequel ledit panneau de brassage est optique.

10. Dispositif pour ranger des cordons de brassage selon la revendication 9, dans lequel ledit panneau de brassage comprend des coupleurs LC.

11. Dispositif pour ranger des cordons de brassage selon la revendication 8, dans lequel ledit dispositif comprend un dispositif pour supporter un câble de cordon de brassage horizontalement.

12. Dispositif pour ranger des cordons de brassage selon la revendication 1, dans lequel ledit dispositif a une hauteur d'une ou deux unités, dans lequel 1 unité = 44,45 mm.

13. Dispositif pour ranger des cordons de brassage selon la revendication 1, dans lequel ledit dispositif comporte au moins 24 cavités.

14. Dispositif pour ranger des cordons de brassage selon la revendication 1, dans lequel ledit câble occupe plus d'une dite cavité.

15. Dispositif pour ranger des cordons de brassage selon la revendication 1, dans lequel ladite cavité a des dimensions permettant de placer ledit câble de cordon de brassage en pliant ledit câble avec un rayon non supérieur à son rayon de courbure minimal.
